# EUROPEAN PATENT APPLICATION

(11) **EP 4 745 590 A1**
(43) Date of publication of application: **20.05.2026**
(21) Application number: 24212784.3
(22) Date of filing: 13.11.2024
(51) Int. Cl.: G01R 31/327, H01H 47/00

(54) **MONITORING CIRCUIT FOR REDUNDANT RELAYS**

(71) Applicant: Pepperl+Fuchs SE, 68307 Mannheim (DE)
(72) Inventor: Klotz, Kai, 68307 Mannheim (DE)
(74) Representative: Banse & Steglich Patentanwälte PartmbB

(57) **Abstract**

The invention relates to a monitoring device (1) for monitoring operability of serially connected redundancy cutoff relays(31), comprising:
- a resonance circuit (4) configured to be connected in parallel to each of the serially connected cutoff relays (31), wherein each of the resonance circuits (4) comprise a primary inductivity (41);
- a transformer (5) for each of the resonance circuits (4) formed by the resepctive primary inductivity (41) and a respective secondary inductivity (51);
- a excitation circuit (7) for injecting an excitation pulse into the resonance circuits (4) by means of the secondary inductivities (51) of the transformers (5);
- a detection circuit (6) configured to receive oscillation responses of the secondary inductivities (51) caused by an oscillation in the resonance circuits (4) initiated by the excitation pulse (Vₚᵤₗₛₑ) and to output an output signal (S) indicating that a failure in the redundancy cutoff relays (31) occurred if the oscillation responses are different.

## Description

### Technical field

The present invention relates to cutoff relays for shutting down the operation of a load. The invention further relates to the monitoring of operability of cutoff relays used for functional safety.

### Technical background

In automation technology, the control of power components, for example valves, motors, or other electromechanical components, represents the interface between logic and actuators. The use of relays has proven itself for controlling said power components with low-power control signals. In applications with the aspect of functional safety, the focus is on transferring the operation to the safe state. The aim is to ensure that safe switching of the load is possible. As the safety integration level increases, so do the requirements for diagnostic coverage in order to detect a dangerous failure.

A common means of implementing such diagnostics are so-called positively driven relays, which are equipped with a further pair of contacts in addition to the switching contact. Both contact pairs are mechanically coupled so that the second contact pair can be used to extend the switching state of the relay. Although this approach is widely used due to its simplicity, it is structurally demanding, which is why, in addition to the increased space requirement compared to conventional relays, the costs also increase significantly. This problem becomes much more pronounced when a redundant relay design is required. In this case, the space requirement and costs increase significantly again, not least because the diagnostics now also have to monitor two relays. This applies equally to alternative diagnostic circuits, which usually work with an increased effort for measurement and tend to be more complex, which also increases the space required and the costs.

In addition to the use of positively driven relays, a common way of detecting the state of a relay is to measure the current flow via a shunt resistor. This can be done via a test current or the load current itself. The relays are also switched in different sequences in order to be able to test the switching operation of each of the serial relays individually. However, this diagnosis requires a minimum load current and is dependent on the polarity of the applied voltage. The diagnosis is also not electrically isolated from the load circuit.

Document US 11,774,501 B2 relates to the evaluation of the current flow in a shunt resistor. Unlike usual, however, the shunt resistor is not located in the load circuit, but located in a magnetically coupled test circuit. The coupling takes place via a transformer, which provides a different impedance for the evaluation depending on the state of the load circuit. Test signals of a defined frequency are used to provide the signal change via the shunt resistor to an evaluation unit for measurement, which thus diagnoses the status of the relay. Due to the impedance detection and the dependency on the frequency spectrum, the evaluation is more complex. This is exacerbated by sources of interference, which also influence the signal and its quality and require signal conditioning.

An approach to indirectly monitor the status of the switching contacts is described in document DE10 2011 075 935 A1. Here, the property of the relay itself is used to conclude the functionality or the fault. The coil contained in the relay also acts as a sensor element, which allows conclusions to be drawn about the current change due to magnetic flux during the switching process and thus obtains information about the armature position. A fault, such as the welding of the load contacts, which causes a change in the switching characteristic, can thus be detected. While this method allows a very good decoupling of the load circuit, the evaluation of the coil current over time is quite demanding. It requires extensive signal conditioning which further increases the complexity.

As described above, for functional safety, loads are usually coupled with cutoff relays, which allow to safely disconnect the load from any electrical power source. To provide redundancy, two serially connected cutoff relays may be applied which are synchronously controlled by means of a cutoff signal in case of a cutoff event.

To ensure that redundancy is maintained, a diagnosis has to be made regularly, making sure that both cutoff relays are fully functional, particularly to ensure that none of the relays has a stuck-closed fault. Furthermore, if one of the cutoff relays opens the circuit due to a safety function, it has to be reliably detected that the one cutoff relay has a fault so that the other cutoff relay can be opened to bring the circuitry into a safe state.

It is an object of the present invention to provide a monitoring circuitry which can detect the operability of a redundant cutoff relay device which is galvanically isolated from the load and which provides a quick diagnosis response.

### Summary of the invention

This object has been achieved by a monitoring circuit for redundant cutoff relays according to claim 1 and the method for operating a monitoring circuit according to the further independent claim.

Further embodiments are indicated in the depending subclaims.

According to a first aspect a monitoring device for monitoring operability of serially connected redundancy cutoff relays is provided, comprising:
- A resonance circuit configured to be connected in parallel to each of the serially connected cutoff relays, wherein each of the resonance circuits comprise a primary inductivity;
- a transformer for each of the resonance circuits formed by the primary inductivity and a secondary inductivity;
- a excitation circuit for injecting an excitation pulse into the resonance circuits by means of the secondary inductivities of the transformers;
- a detection circuit configured to receive oscillation responses of the secondary inductivities caused by an oscillation in the resonance circuits initiated by the excitation pulse and to output an output signal indicating that a failure in the redundancy cutoff relays occurred if the oscillation responses are different.

Functional safety cutoff devices usually include a pair of redundant cutoff relays which are serially connected with each other and with a load so that by means of a control signal the load can be disconnected from a power source by opening a current path over the load. The provision of redundancy shall ensure that switching of the load can be effected even if one of the cutoff relays is dysfunctional.

To ensure that redundancy is always maintained, monitoring is required which detects when one of the cutoff relays has a stuck-closed fault. The stuck-closed fault may occur if the two electrodes of the relay stick together after an open-control signal due to local melting of the electrode material due to a spark event which results in welding the electrodes.

The above monitoring device comprises a serial resonance circuit including a capacity and an inductivity serially connected with each other in parallel with each of the cutoff relays. The inductivities are magnetically coupled with secondary inductivities, thereby forming transformers. This allows a galvanic decoupling from the current path of the load circuit.

It may be provided that the secondary inductivities are interconnected or serially coupled with their first terminals, wherein the excitation pulse is applied onto their second terminals, wherein the second terminals are connected to the detection circuit to provide the oscillation response.

It may be provided that a test voltage potential is applied to the first terminals of the secondary inductivities via a test voltage source, wherein the test voltage source is coupled to the first terminals via a diode so as to avoid current backflow. So, the secondary inductivities may be connected at a first terminal with a test voltage potential and with their second terminals with a semiconductor switch respectively.

The semiconductor switches allow to simultaneously inject an excitation pulse. The excitation pulse is generated by closing the semiconductor switches briefly. This may result in that their second terminals are connected with a reference voltage potential while the first terminals are connected with a test voltage related to the reference voltage potential.

The excitation pulse is inductively coupled into the primary inductivities of the resonance circuits so that the resonant circuits start an attenuated oscillation. If both cutoff relays are opened, the resonance circuits are serially coupled with the load so that both resonance circuits carry the same current.

Preferably, both resonant circuits may be identical in their configuration so that the attenuated oscillation of the resonant circuit is coupled into the secondary inductivities of the transformers, which currently act passively as the excitation pulse has ended.

The oscillation coupled into the secondary inductances of the transformers are synchronous due to an identical configuration and parametrization of the resonance circuits. Therefore, the attenuated oscillation coupled into the secondary side of the transformers are synchronous.

The second terminals of the secondary inductivities are coupled to a detection circuit. The detection circuit is configured to detect a deviation between the two oscillations in phase, in amplitude and/or frequency. If a deviation occurs, it is detected that the resonance circuits have different oscillation characteristics which can only occur if the switching state of one of the cutoff relays is different from the switching state of the other cutoff relay.

In a preferred embodiment, the detection circuit may comprise a full bridge rectifier buffered by a buffer capacity, so that a voltage difference between the voltages at the second terminals of the secondary inductivities is rectified, wherein the rectified voltage difference is amplified to obtain a digital output signal indicating whether or not a voltage difference occurred. The output signal of the detection circuit may signal a fault in the two cutoff relays.

It may be provided that the secondary inductivities are serially connected in an antiserial (different winding directions) manner, so that noise or interferences coupled into the resonance circuits result in opposite polarity signals at the secondary inductivities which are compensated in the detection circuit.

Hence, the secondary inductivities are formed as coils wherein the polarity of the coils of the two secondary coils is opposite to each other. Thereby, EMC signals coupled into the primary sides of the transformers, which may occur at the contacts of the cutoff relays, are eventually compensated. The EMC signals occur with the same polarity on the primary side, while on the secondary sides of the transformers, the EMC signal do compensate each other so that the monitoring can be made more robust. This antiserial operation of the transformers enable compensation of noise and EMC interferences from the load circuit itself, which improves the susceptibility to any kind of disturbances. This is beneficial as the EMC guidelines are more strictly interpreted in terms of functional safety.

The above monitoring device is particularly appropriate for redundant relay use. The switching contacts are electrically isolated from the diagnostic circuit, which reduces the load on the components and may help to increase interference immunity. This improves the simplicity of the detection circuit, which also reduces space requirements and costs. In addition, the above monitoring device monitors both relays and therefore does not have to be redundant which also contributes to low space requirements and costs. Furthermore, the above monitoring device can be applied for a wide voltage range for AC and DC applications with large load range (low to high impedance loads).

Compared to monitoring of the relay states via a shunt resistor in the load circuit, the advantage of above monitoring device is that a decoupling between the control and load circuit can take place. This allows a clear separation of the functional and monitoring devices, which facilitates fault analysis with regard to functional safety (especially IEC 61508 and ISO 13849). At the same time, decoupling also reduces the requirements on the components of the above monitoring device. The dielectric strength is based on the monitoring device and not the load circuit, which means that the separation distances between the components can also be significantly smaller.

Furthermore, the control of the monitoring device is not affected by the amount of load current and allows a wide range of load currents as well as a large voltage range.

### Brief description of the drawings

Embodiments are described in more detail in conjunction with the accompanying drawings in which:
- Figure 1: shows a schematic of a circuitry of the diagnosis device of the present invention; and
- Figure 2: shows a more detailed schematic of the diagnosis device as a specific embodiment of the present invention.

### Description of embodiments

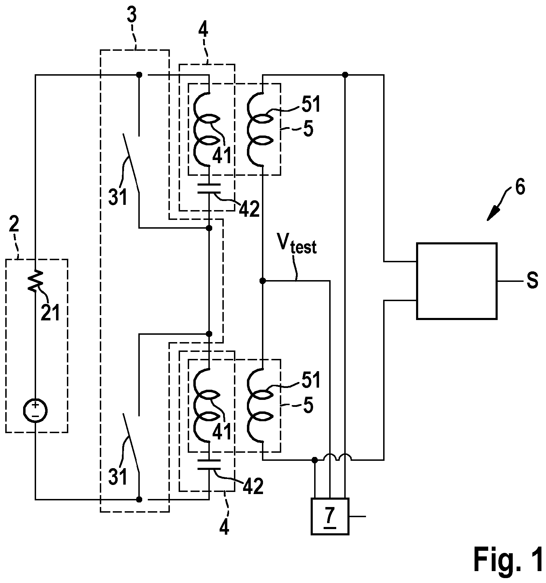

Figure 1 schematically shows the functional principle of the monitoring device according to the present invention.

In a load circuit 2 is formed by a serial connection of a load 21 and a voltage source 22 powering the load 21. The load circuit 2 is serially coupled with a redundant switch unit 3 comprising two serially electrically connected cutoff relays 31 so that when both cutoff relays are closed, a current can flow through the load circuit 2. The cutoff relays 31 are to be switched identically (both closed or both opened) in normal operation. In case that at least one of the cutoff relays 31 is open, the load circuit 2 is deactivated. In operation, the load circuit 2 is operated by closing both of the cutoff relays 31, and the load 21 is passive when at least one of the cutoff relays 31 is opened.

As a functional safety feature, the redundant cutoff relays 31 are required to allow to disconnect the load 21 from the voltage source even if one of the cutoff relays 31 is stuck-closed.

The monitoring device 1 comprises two identical resonance circuits 4 being in parallel to the cutoff relays 31. The resonance circuits 4 comprise a serial connection of an inductivity 41 and capacity 42 which may provide resonance characteristics with a first time constant if the associated cutoff relay is closed and provide resonance characteristics with a second time constant in case the associated cutoff relay 31 is opened. In the first case, the attenuation is much higher as the current through the respective resonance circuit 4 also flows through the load 21 so that the oscillation diminishes much quicker compared to the case where the associated cutoff relay 31 is opened.

The inductivities 41 of the resonance circuits 4 may be formed as a part of a respective transformer 5 having a secondary inductivity 51 magnetically coupled with the primary inductivity formed by the inductivity 41 of the resonance circuit 4.

Both secondary inductivities 51 are referenced with a common test voltage potential Vtest via their respective first terminals while the second terminals of the secondary inductivities 51 are connected with a detection circuit 6 allowing to detect different voltage responses over the secondary inductivities 51 and providing a corresponding output signal indicating the different voltage responses in case of a failure.

Furthermore, an excitation circuit 7 is provided which allows to simultaneously excite the resonance circuits by applying an excitation pulse through the secondary inductivities 51 which are magnetically coupled with the primary side inductivities 41 of the resonance circuits 4. This starts an oscillation, the attenuation, the amplitude, and the frequency of which is determined by the switching states of the cutoff relays.

As long as both cutoff relays 31 have the same switching state which signals an ordinary functional behavior, the oscillation of both resonance circuits 4 is synchronous. After the excitation pulse Vₚᵤₗₛₑ has ended, the oscillation of the resonance circuits 4 couples into the respective secondary inductances 51, thereby providing voltage characteristics at its output.

By means of the detection circuit 6, the voltage characteristics are compared over the time of the remaining oscillation, and the output signal S is obtained. The output signal S indicates whether or not the voltage characteristics are different over the time during which the oscillation diminishes. So, the output signal S indicates a failure of the cutoff relays 31 if it is detected that the resonant circuits have different attenuation, amplitudes and/or frequencies. These can be used to determine if a faulty state has occurred in the switching unit 3.

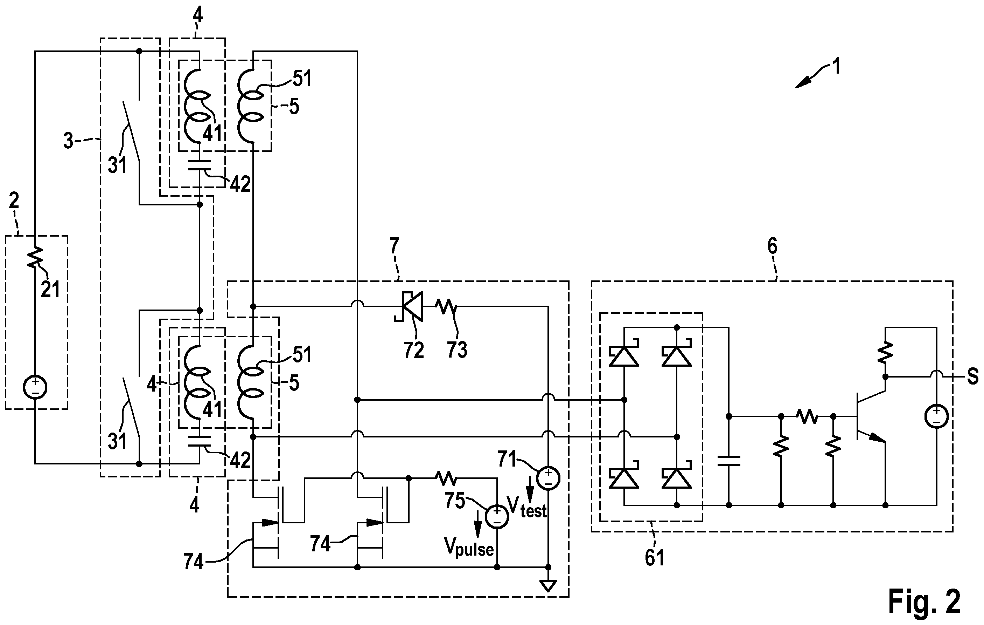

Fig. 2 shows a specific embodiment of the present invention with more detailed description of a possible excitation circuit 7 and detection circuit 6. For the excitation circuit 7 the secondary inductivities 51 are serially connected and connected with their first terminals with a test voltage source 71 which provides a test voltage Vₜₑₛₜ. The test voltage source 71 is coupled via a series connection of a diode 72 and a resistor 73 to avoid a backflow of current through the test voltage source 71.

The second terminals of the primary inductivities 51 are each coupled with a respective semiconductor switch 74 which are controlled by means of a excitation pulse source 75. By activating the excitation pulse source 75 (via a control unit or the like) to output a test excitation Vₚᵤₗₛₑ, the secondary inductivities 51 are shortly energized via closed semiconductor switches 74 to inject energy onto the primary side of the transformers 5, thereby exciting the resonance circuits 4 to start oscillation.

For the detection circuit 6, the second terminals of the secondary inductivities 51 are coupled with two inputs of a full-bridge rectifier 61 which is buffered by a capacity 62 so that when the voltages characteristics at the second terminals are exactly in phase, a voltage level of 0 V occurs at the output of the rectifier.

The output of the full-bridge rectifier 61 is coupled with an emitter circuit 63 to amplify the charge accumulated in the buffer capacity 62 and to output a digital output signal S.

The secondary inductivities 51 may have opposite polarities with respect to their first and second terminals. This induces a counterphase oscillation in both of the resonance circuits 4 and after the excitation pulse has ended the counterphase oscillation are coupled back into the secondary inductivities 51 as in-phase oscillations. In case an EMC noise occurs within the load circuit 2, this is coupled to the full-bridge rectifier 61 as counterphase EMC signals which compensate each other so that they do not affect the diagnosis result.

## Claims

1. Monitoring device (1) for monitoring operability of serially connected redundancy cutoff relays(31), comprising:
- a resonance circuit (4) configured to be connected in parallel to each of the serially connected cutoff relays (31), wherein each of the resonance circuits (4) comprise a primary inductivity (41);
- a transformer (5) for each of the resonance circuits (4) formed by the resepctive primary inductivity (41) and a respective secondary inductivity (51);
- a excitation circuit (7) for injecting an excitation pulse into the resonance circuits (4) by means of the secondary inductivities (51) of the transformers (5);
- a detection circuit (6) configured to receive oscillation responses of the secondary inductivities (51) caused by an oscillation in the resonance circuits (4) initiated by the excitation pulse (Vₚᵤₗₛₑ) and to output an output signal (S) indicating that a failure in the redundancy cutoff relays (31) occurred if the oscillation responses are different.

2. Monitoring device (1) according to claim 1, wherein each of the transformers (5) and/or each of the resonance circuits (4) have identical electrical characteristics.

3. Monitoring device (1) according to claim 1 or 2, wherein the secondary inductivities (51) are serially coupled with their first terminals, wherein the excitation pulse (Vₚᵤₗₛₑ) is applied onto their second terminals, wherein the second terminals are connected to the detection circuit to provide the oscillation response.

4. Monitoring device (1) according to claim 3, wherein a test voltage (Vₜₑₛₜ) potential is applied to the first terminals of the secondary inductivities (51) via a test voltage source (71), wherein the test voltage source (71) is coupled to the first terminals via a diode (72) so as to avoid current backflow.

5. Monitoring device (1) according to any of the claims 1 to 4, wherein the detection circuit (6) comprises a full bridge rectifier (61) buffered by a buffer capacity, so that a voltage difference between the voltages at the second terminals of the secondary inductivities is rectified, wherein the rectified voltage difference is amplified to obtain a digital output signal indicating whether or not a voltage difference occurred.

6. Monitoring device (1) according to any of the claims 1 to 5, wherein the secondary inductivities (51) are serially connected in an antiserial manner, so that noise or interferences coupled into the resonance circuits (4) result in opposite polarity signals at the secondary inductivities (51) which are compensated in the detection circuit (6).

7. Monitoring method (1) for monitoring operability of serially connected redundancy cutoff relays (31), wherein a monitoring device (1) comprises:
- a resonance circuit (6) configured to be connected in parallel to each of the serially connected cutoff relays (31), wherein each of the resonance circuits comprise a primary inductivity (41);
- a transformer (5) for each of the resonance circuits (4) formed by the primary inductivity (41) and a secondary inductivity (51);
wherein the monitoring method comprises the steps of:
- injecting an excitation pulse (Vₚᵤₗₛₑ) into the resonance circuits (4) by means of the secondary inductivities (51) of the transformers (5);
- receiving oscillation responses of the secondary inductivities (51) caused by an oscillation in the resonance circuits (4) initiated by the excitation pulse (Vₚᵤₗₛₑ); and
- outputting an output signal (S) indicating that a failure in the redundancy cutoff relays (31) occurred if the oscillation responses are different.
